# EUROPEAN PATENT SPECIFICATION

(11) **EP 1 154 560 B1**
(45) Date of publication and mention of the grant of the patent: **01.09.2004**
(21) Application number: 01302707.3
(22) Date of filing: 23.03.2001
(51) Int. Cl.: H03B 5/12, H03B 5/18

(54) **Voltage controlled oscillator for oscillating signals with high C/N ratio**
Spannungsgesteuerter Oszillator für oszillerende Signale mit einem hohen Signal-Rausch-Verhältnis
Oscillateur commandé en tension pour des signaux oscillants avec un rapport signal/bruit élevé

(30) Priority: 18.04.2000 JP 2000122384
(43) Date of publication of application: 14.11.2001
(73) Proprietor: ALPS ELECTRIC CO., LTD., Ota-ku Tokyo 145 (JP)
(72) Inventor: Igarashi, Yasuhiro, Alps Electric Co., Ltd., Tokyo 145 (JP)
(74) Representative: Kensett, John Hinton

(56) References cited:
- US-A- 4 189 690
- US-A- 4 684 904
- PATENT ABSTRACTS OF JAPAN vol. 009, no. 131 (E-319), 6 June 1985 (1985-06-06) & JP 60 018024 A (TOSHIBA KK), 30 January 1985 (1985-01-30)

## Description

### BACKGROUND OF THE INVENTION

### 1. Field of the Invention

The present invention relates to voltage controlled oscillators using microstrip lines as resonant circuits, and more particularly, it relates to a voltage controlled oscillator suitable for oscillating in a high frequency band.

### 2. Description of the Related Art

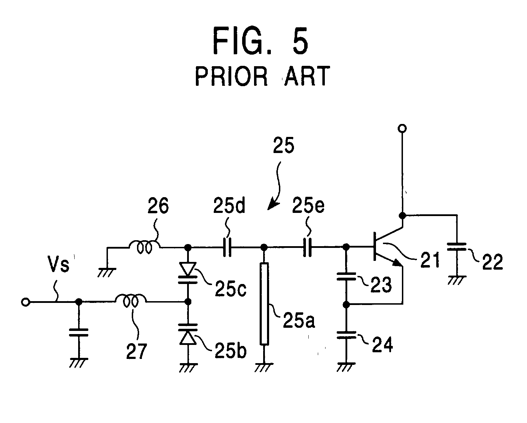

Fig. 5 shows the structure of a conventional voltage controlled oscillator formed on a printed circuit board (not shown). The collector of an oscillating transistor 21 is grounded at high frequencies by a DC-blocking capacitor 22. A feedback capacitor 23 is connected between the base and the emitter of the oscillating transistor 21, and a feedback capacitor 24 is connected between the emitter and the ground.

A resonant circuit 25 provided between the base of the oscillating transistor 21 and the ground forms a so-called λ/4 resonant circuit. The resonant circuit 25 includes a microstrip line 25a grounded at one end and first and second varactor diodes 25b and 25c the cathodes of which are connected to each other. The anode of the first varactor diode 25b is grounded, and the anode of the second varactor diode 25c is connected to the other end of the microstrip line 25a through a DC-blocking capacitor 25d. The other end of the microstrip line 25a is connected to the base of the oscillating circuit 21 by a Clapp capacitor 25e.

The microstrip line 25a is a line conductor formed on the printed circuit board. The length of the microstrip line 25a is slightly shorter than a quarter of the wavelength of an oscillation frequency.

The anode of the second varactor diode 25c is grounded through a choke inductor 26. A control voltage is applied to the cathode of the first varactor diode 25b and the cathode of the second varactor diode 25c through a choke inductor 27. By changing the value of the control voltage, the oscillation frequency can be changed.

In the foregoing arrangement, the smallest capacitance of each of the varactor diodes is limited by the structure. In order to oscillate at a high frequency, the capacitance increases while the Q factor of the resonant circuit decreases. Hence the carrier-to-noise (C/N) ratio of an oscillation signal decreases.

Further details in relation to conventional oscillators can be found in JP-A-60 018024, US-A-4,684,904 and US-A-4,189,690.

### SUMMARY OF THE INVENTION

Accordingly, it is an object of the present invention to increase the Q factor of a resonant circuit, thereby obtaining an oscillation signal with a high C/N ratio.

According to an aspect of the present invention there is provided a voltage controlled oscillator comprising: an oscillating transistor grounded at the collector thereof at high frequencies; a microstrip line; first varactor diode, and a second varactor diode connected to one end of said microstrip line, the anode of the first varactor diode being grounded by a first choke inductor and being connected to the base of said oscillating transistor via a capacitor, and the cathode of the second varactor diode being connected to the other end of the microstrip line, and the anode of the second varactor diode being grounded, said voltage controlled oscillator being characterised in that the length of said microstrip line is set in a range of ½ to ¾ of a wavelength of an oscillation frequency, and a control voltage to be supplied to the cathode of said first varactor diode and the cathode of said second varactor diode is applied at a position near a voltage node point on said microstrip line.

One end of a second choke inductor may be connected to the voltage node point. The control voltage may be applied to the other end of the second choke inductor.

The microstrip line is longer than a conventional one, and hence the Q factor of a resonant circuit increases. As a result, the C/N ratio of an oscillation signal increases. Also, a deterioration of the Q factor of the resonant circuit, which is caused by applying a control voltage, does not occur. A second choke inductor does not require a large inductance, and hence the second choke inductance can be formed of a short microstrip line or the like.

An embodiment of the present invention, will now be described, by way of example only, with reference to the accompanying diagrammatic drawings, in which:
Fig. 1 is a circuit diagram of a voltage controlled oscillator;
Fig. 2 is a circuit diagram of a resonant circuit in the voltage controlled oscillator;
Fig. 3 illustrates a voltage standing wave on a microstrip line in the voltage controlled oscillator;
Fig. 4 is a circuit diagram of a voltage controlled oscillator according to the invention; and
Fig. 5 is a circuit diagram of a conventional voltage controlled oscillator.

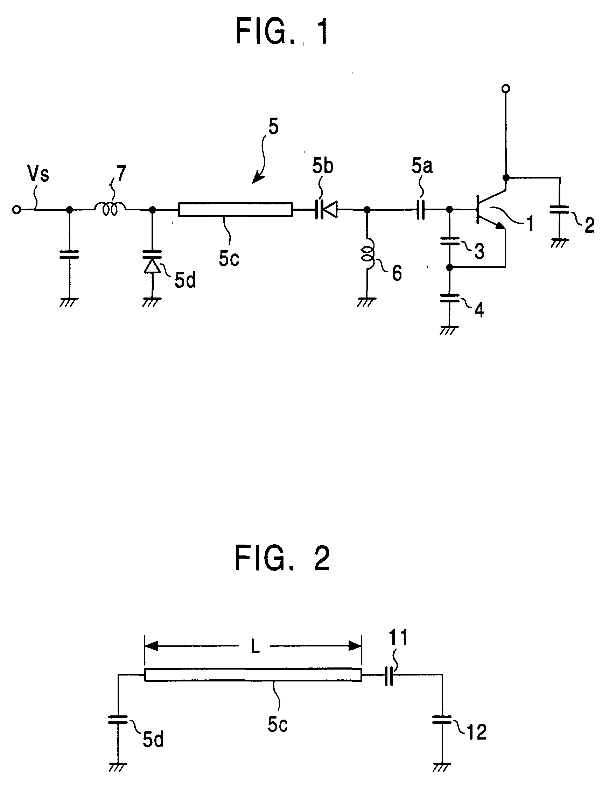

Referring to Fig. 1, the collector of an oscillating transistor 1 is grounded at high frequencies by a DC-blocking capacitor 2. A feedback capacitor 3 is connected between the base and the emitter of the oscillating transistor 1, and a feedback capacitor 4 is connected between the emitter and the ground. A bias circuit for applying a DC bias voltage to the base and the emitter is omitted.

A resonant circuit 5 provided between the base and the ground is formed of a series resonant circuit including a Clapp capacitor 5, a first varactor diode 5b, a microstrip line 5c, and a second varactor diode 5d. The anode of the first varactor diode 5b is connected to the base of the oscillating transistor 1 through the Clapp capacitor 5a, and the cathode of the first varactor diode 5b is connected to one end of the microstrip line 5c. The other end of the microstrip line 5c is connected to the cathode of the second varactor diode 5d, and the anode of the second varactor diode 5d is grounded. The length L of the microstrip line 5c is set in a range of 1/2 to 3/4 of the wavelength of an oscillation frequency (preferably the length L is set to slightly longer than 1/2 of the wavelength).

The anode of the first varactor diode 5b is DC-grounded by a first choke inductor 6. A control voltage Vs is applied to the node between the cathode of the second varactor diode 5d and the microstrip line 5c through a second choke inductor 7. The control voltage is also applied to the cathode of the first varactor diode 5b through the microstrip line 5c. The capacitance of the first varactor diode 5b and the capacitance of the second varactor diode 5d change in association with each other.

Circuit components, such as the oscillating transistor 1, the first and second varactor diodes 5b and 5d, and the like, of the foregoing structure are mounted on a printed circuit board (not shown). The microstrip line 5c is a line conductor formed of conductive foil adhered on the top surface of the printed circuit board.

Since the resonant circuit 5 is connected in parallel to the serially-connected feedback capacitors 3 and 4, one end of the microstrip line 5c is terminated by the second varactor diode 5d, and the other end of the microstrip line 5c is terminated by a series circuit of a lumped capacitance 11, which includes the first varactor diode 5b and the Clapp capacitor 5a, and a lumped feedback capacitor 12. Referring to Fig. 2, the overall resonant circuit forms a so-called λ/2 resonant circuit. The resonant circuit oscillates at an oscillation frequency of the overall resonant circuit. The λ/2 resonant circuit is a series resonant circuit. Since the length L of the microstrip line 5c is within the range of λ/2 to 3λ/4, the length L is longer than that in the prior art. As a result, the Q factor of the overall resonant circuit increases.

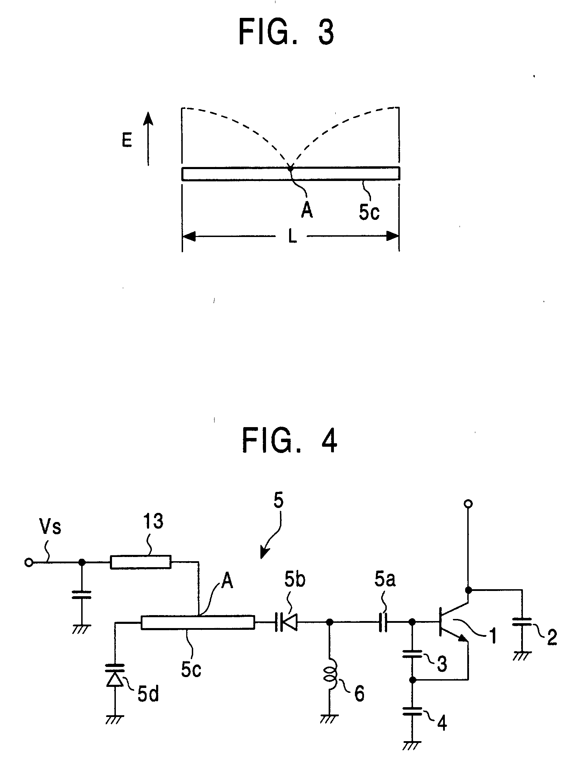

Referring to Fig. 3, since the length L of the microstrip line 5c is increased, a voltage node point A appears at the center of the microstrip line 5c in the longitudinal direction. The position of the voltage node point A slightly deviates in accordance with variation in the capacitance of the first and second varactor diodes 5b and 5d. Since the first and second varactor diodes 5b and 5d are arranged so as to be opposed to both ends of the microstrip line 5c, the deviation is small even when the oscillation frequency varies.

The potential at the voltage node point A is the same as the potential at the ground at high frequencies. Thus, the impedance between the voltage node point A and the ground is substantially decreased. When another circuit element is connected to the voltage node point A, the oscillation frequency does not change very much. Referring to Fig. 4, which shows a voltage controlled oscillator according to the invention, a choke inductor 13 is connected to the voltage node point A of the microstrip line 5c, and a control voltage is applied through the choke inductor 13. In this way, the necessary inductance of the choke inductor 13 is small. Thus, the choke inductor 13 can be formed of a short microstrip line.

## Claims

1. A voltage controlled oscillator comprising:
an oscillating transistor (1) grounded at the collector thereof at high frequencies;
a microstrip line (5c); first varactor diode (5b), and a second varactor diode (5d) connected to one end of said microstrip line, the anode of the first varactor diode being grounded by a first choke inductor (6) and being connected to the base of said oscillating transistor via a capacitor (5a), and the cathode of the second varactor diode being connected to the other end of the microstrip line, and the anode of the second varactor diode being grounded, said voltage controlled oscillator being **characterised in that** the length of said microstrip line (5c) is set in a range of ½ to ¾ of a wavelength of an oscillation frequency, and a control voltage to be supplied to the cathode of said first varactor diode (5b) and the cathode of said second varactor diode (5d) is applied at a position near a voltage node point on said microstrip line (5c).

2. A voltage controlled oscillator according to Claim 1, wherein:
one end of a second choke inductor (13) is connected to the voltage node point (A); and
the control voltage is applied to the other end of said second choke inductor.

## Patentansprüche

1. Spannungsgesteuerter Oszillator, aufweisend:
einen oszillierenden Transistor (1), der an dessen Kollektor bei hohen Frequenzen geerdet ist;
eine Mikrostreifenleitung (5c);
eine erste Varaktordiode (5b) und eine zweite Varaktordiode (5d), die an ein Ende der Mikrostreifenleitung angeschlossen sind, wobei die Anode der ersten Varaktordiode durch eine erste Drosselinduktivität (6) geerdet ist und über einen Kondensator (5a) an die Basis des oszillierenden Transistors angeschlossen ist und die Kathode der zweiten Varaktordiode an das andere Ende der Mikrostreifenleitung angeschlossen ist und die Anode der zweiten Varaktordiode geerdet ist, wobei der spannungsgesteuerte Oszillator **dadurch gekennzeichnet ist, dass** die Länge der Mikrostreifenleitung (5c) in einem Bereich von 1/2 bis 3/4 einer Wellenlänge einer Oszillationsfrequenz festgelegt ist und eine an die Kathode der ersten Varaktordiode (5b) und die Kathode der zweiten Varaktordiode (5d) zu liefernde Steuerspannung bei einer Position in der Nähe eines Spannungsknotenpunktes der Mikrostreifenleitung (5c) angelegt wird.

2. Spannungsgesteuerter Oszillator nach Anspruch 1, bei welchem:
ein Ende einer zweiten Drosselinduktivität (13) an den Spannungsknotenpunkt (A) angeschlossen ist; und
die Steuerspannung an das andere Ende der zweiten Drosselinduktivität angelegt wird.

## Revendications

1. Oscillateur commandé en tension, comprenant :
un transistor oscillant (1) mis à la masse au collecteur de celui-ci aux hautes fréquences ;
une ligne microruban (5c) ; une première diode à capacité variable (5b), et une seconde diode à capacité variable (5d) connectées à une extrémité de ladite ligne microruban, l'anode de la première diode à capacité variable étant mise à la masse par une première bobine de lissage (6) et étant connectée à la base dudit transistor oscillant via un condensateur (5a), et la cathode de la seconde diode à capacité variable étant connectée à l'autre extrémité de la ligne microruban, et l'anode de la seconde diode à capacité variable étant mise à la masse, ledit oscillateur commandé en tension étant **caractérisé en ce que** la longueur de ladite ligne microruban (5c) est choisie dans une plage allant de ½ à ¾ d'une longueur d'onde d'une fréquence d'oscillation, et une tension de commande à fournir à la cathode de ladite première diode à capacité variable (5b) et à la cathode de ladite seconde diode à capacité variable (5d) est appliquée à une position proche d'un point de noeud de tension sur ladite ligne microruban (5c).

2. Oscillateur commandé en tension selon la revendication 1, dans lequel :
une extrémité d'une seconde bobine de lissage (13) est connectée au point de noeud de tension (A) ; et
la tension de commande est appliquée à l'autre extrémité de ladite seconde bobine de lissage.
